(19) Europäisches Patentamt
European Patent Office
Office européen des brevets

(11) **EP 2 424 061 A2**

(12) **EUROPEAN PATENT APPLICATION**

(43) Date of publication:
**29.02.2012 Bulletin 2012/09**

(51) Int Cl.:
**H02H 1/00** *(2006.01)*

(21) Application number: **11179616.5**

(22) Date of filing: **31.08.2011**

| | |
|---|---|
| (84) Designated Contracting States:<br>**AL AT BE BG CH CY CZ DE DK EE ES FI FR GB GR HR HU IE IS IT LI LT LU LV MC MK MT NL NO PL PT RO RS SE SI SK SM TR**<br>Designated Extension States:<br>**BA ME** | (72) Inventors:<br>• **Xu, Jian**<br>  **Windsor, Ontario N9B 3V9 (CA)**<br>• **Finch, John Gerrard**<br>  **Livonia, Michigan 48152 (US)** |
| (30) Priority: **31.08.2010 US 378408 P** | (74) Representative: **Croston, David**<br>**Withers & Rogers LLP**<br>**4 More London Riverside**<br>**London**<br>**SE1 2AU (GB)** |
| (71) Applicant: **MASCO CORPORATION**<br>**Taylor, MI 48180 (US)** | |

(54) **Branch circuit protection with in-line solid state device**

(57) A method of protecting against overcurrent conditions controls a solid state switch to turn OFF to prevent a flow of current along a first current path in response to an overcurrent condition exceeding a predefined current threshold, or a predefined current threshold and a predefined energy threshold. Current is selectively passed along a second current path that is parallel to the first current path in response to the solid state switch turning OFF. An overcurrent detection device that is upstream of the first current path and the second current path is used to detect at least partially via the second current path whether the overcurrent condition corresponds to a predefined fault condition downstream of the current paths.

FIG.1

**Description**

**BACKGROUND**

This disclosure relates to protection of branch circuits, and more particularly to overcurrent protection of a branch circuit with an in-line solid state switch.

Modern building codes, such as the National Electric Code 2008, require arc fault circuit interrupter ("AFCI") devices to be used on numerous branch circuits in a home. AFCI devices are operable to de-energize a branch circuit in response to detected current signatures indicative of arcing and sparking. However, the response time of AFCI devices is slow enough that a downstream solid-state control device may be damaged before the AFCI device can de-energize its associated branch circuit.

**SUMMARY**

A method of protecting against overcurrent conditions controls a solid state switch to turn OFF to prevent a flow of current along a first current path in response to an overcurrent condition exceeding a predefined current threshold and a predefined energy threshold. Current is selectively passed along a second current path that is parallel to the first current path in response to the solid state switch turning OFF. An overcurrent detection device that is upstream of the first current path and the second current path is used to detect at least partially via the second current path whether the overcurrent condition corresponds to a predefined fault condition downstream of the current paths.

According to a first aspect of the invention, there is provided at least one first current path including a load and a switch operable to control a flow of current to the load; a second current path connected in parallel to the at least one first current path, the second current path including a transient voltage suppression ("TVS") device; and an overcurrent detection device upstream of the current paths, wherein the switch is operable to turn OFF to prevent a flow of current through the first current path in response to an overcurrent condition exceeding a predefined threshold, such that the overcurrent detection device is operable to detect at least partially through the second current path if the overcurrent condition corresponds to a predefined fault condition.

Preferably, the load includes a lighting load, and the switch is operable to perform a dimming function on the lighting load.

In one embodiment, there is provided a sensing module operable to detect when the current in the first current path exceeds the predefined thresholds, and operable to command a switch control to turn the switch ON or OFF.

In one embodiment, there is provided an inductive winding connected between the overcurrent detection device and the two current paths, the inductive winding discharging stored energy in response to the switch turning OFF, the energy being discharged as current into the TVS device such that the TVS device begins conducting if the energy stored in the inductive winding exceeds a TVS conduction threshold.

Preferably, the TVS device includes at least one of a zener diode or a metal oxide varistor, and the switch is a solid state switch.

The at least one current path may include a plurality of first current paths, each of the plurality of first current paths corresponding to a channel of a multi-channel controller, each channel having its own individually controllable load, such that only a single second current path is needed for the multi-channel controller.

The overcurrent detection device may include at least one of an arc fault circuit interrupter, a ground fault circuit interrupter, or a standard circuit breaker, and the predefined fault condition may include at least one of an arc fault condition, a ground fault condition, or an overcurrent condition of a predefined magnitude.

The predefined threshold is preferably at least a current threshold and/or an energy threshold.

According to a second aspect of the invention, there is provided an electrical circuit, comprising an overcurrent detection device; a solid state switch downstream of the overcurrent detection device forming a first current path; an electromechanical switch forming a second current path parallel to the first current path; and a load downstream of the current paths, wherein if a flow of current to the load exceeds a predefined threshold the solid state switch turns OFF and the electromechanical switch turns ON to protect the solid state switch from the overcurrent condition, enabling the overcurrent detection device to detect through the second current path if the flow of current to the load corresponds to a predefined fault condition.

Preferably, the load includes a lighting load, and the solid state switch is operable to perform a dimming function on the lighting load.

Preferably, the electromechanical switch turns OFF if the solid state switch is ON.

The overcurrent detection device may include at least one of an arc fault circuit interrupter, a ground fault circuit interrupter, or a standard circuit breaker, and the predefined fault condition includes at least one of an arc fault condition, a ground fault condition, or an overcurrent condition of a predefined magnitude.

The predefined threshold is preferably at least a current threshold and/or an energy threshold.

According to a third aspect of the invention, there is provided a method of protecting against overcurrent conditions, comprising controlling a solid state switch to turn OFF to prevent a flow of current along a first current path in response to an overcurrent condition exceeding a predefined threshold; selectively passing current along a second current path that is parallel to the first current path in response to the solid state switch turning OFF; and detecting at least partially via the second current path whether the overcurrent condition corresponds to a predefined fault condition downstream of the current paths using an overcurrent detection device upstream of the first current path and the second current path.

Preferably, the method includes the step of preventing current from flowing through the second current path in response to the solid state switch being ON. In a preferred embodiment, said step of selectively passing current along a second current path that is parallel to the first current path in response to the solid state switch turning OFF includes storing energy in an inductive winding upstream of the two current paths; and discharging the stored energy into a transient voltage suppression ("TVS") device in the second current path in response to the solid state switch turning OFF such that the TVS device can begin conducting if the energy stored in the inductive winding exceeds a TVS conduction threshold.

Alternatively, said selectively passing current along a second current path that is parallel to the first current path in response to the solid state switch turning OFF includes turning ON an electromechanical switch to permit a flow of current along the second current path in response to the solid state switch turning OFF.

The first current path may include a lighting load, and wherein the solid state switch may be operable to perform a dimming function on the lighting load.

The TVS device preferably includes at least one of a zener diode or a metal oxide varistor.

Preferably, a lighting load is located downstream of the first current path and the second current path, and the solid state switch is operable to perform a dimming function on the lighting load when the electromechanical switch is turned OFF. The overcurrent detection device may include at least one of an arc fault circuit interrupter, a ground fault circuit interrupter, or a standard circuit breaker, and the predefined fault condition may include at least one of an arc fault condition, a ground fault condition, or an overcurrent condition of a predefined magnitude.

The predefined threshold is preferably at least a current threshold and/or an energy threshold.

These and other features of the present disclosure can be best understood from the following specification and drawings, the following of which is a brief description.

**BRIEF DESCRIPTION OF THE DRAWINGS**

Figure 1 schematically illustrates an example branch circuit with overcurrent protection.
Figure 2 schematically illustrates another example branch circuit with overcurrent protection.
Figure 3 schematically illustrates an example wireless switching application for the branch circuits of Figures 1-2.

**DETAILED DESCRIPTION**

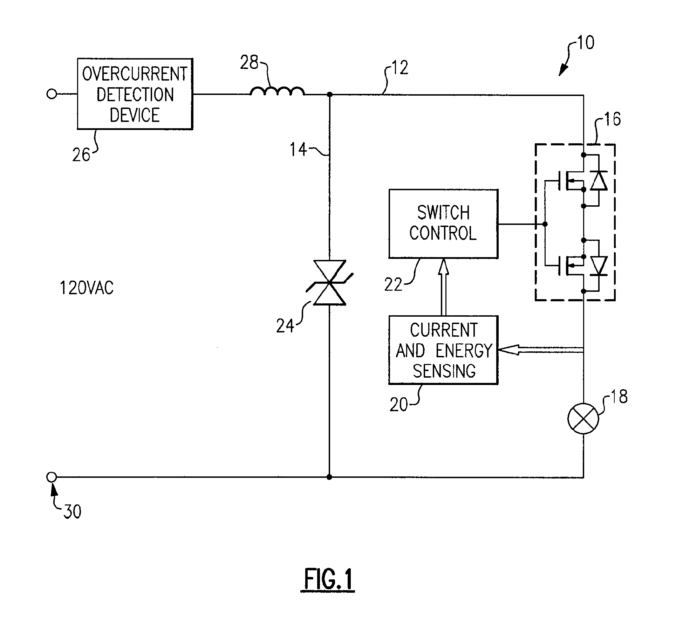

Figure 1 schematically illustrates an example branch circuit 10. The branch circuit 10 includes a first current path 12 and a second current path 14 connected in parallel to the first current path 12. The first current path 12 includes a solid state switch 16 operable to control a flow of current along the first current path 12 to a load 18. In one example the switch 16 includes one or more MOSFETs. In one example the load 18 includes a lighting load, and the switch 16 is operable to perform a dimming function on the lighting load. Of course, other switches 16 and loads 18 could be used.

A current and energy sensing module 20 is operable to determine if a flow of current through the current path 12 exceeds a predefined current threshold and a predefined energy threshold (which would indicate an overcurrent condition). If the flow of current through the current path 12 exceeds the predefined current and energy thresholds (e.g. the current exceeds the predefined current threshold for an amount of time such that the flow of current exceeds the predefined energy threshold) then the current and energy sensing module 20 commands switch control 22 to turn the switch 16 OFF such that the flow of current along path 12 is interrupted. By turning OFF the switch 16, the switch 16 is protected from potential damage from the overcurrent condition.

The second current path 14 includes a transient voltage suppression ("TVS") device 24. In one example the TVS device is a zener diode or a metal oxide varistor ("MOV"). Of course, other TVS devices 24 could be used. Under normal non-fault conditions the TVS is not conducting such that no current passes along the second current path 14, and current is only able to pass through the current path 12 (depending on the state of the switch 16). The branch circuit also includes an overcurrent detection device 26 and an inductor 28 that are both upstream of the current paths 12, 14. In one example the overcurrent detection device 26 includes an arc fault circuit interrupter ("AFCI") device operable to detect if the overcurrent condition corresponds to an arc fault condition. In one example the overcurrent detection device 26 includes a ground fault circuit interrupter ("GFCI") device operable to detect if the overcurrent condition corresponds to a ground fault condition. In one example the overcurrent detection device 26 includes a standard circuit breaker operable to detect if the overcurrent condition corresponds to a current exceeding a certain maximum allowable current threshold. Of course, other overcurrent protection devices could also be used.

In the event of an overcurrent condition downstream of the current paths 12, 14 (e.g. at node 30), the switch 16 turns OFF to stop a flow of current through the first current path 12. As will be discussed below, this abrupt change in current flow causes the inductor 28 to discharge as a voltage spike. If this voltage spike is of a sufficient magnitude, the TVS device 24 begins conducting, and the overcurrent detection device 26 may detect at least partially via the second current path 14 whether the overcurrent condition corresponds to a predefined fault condition. Upon detection of a predefined fault condition (e.g. arc fault condition), the overcurrent detection device 26 (e.g. AFCI device) turns OFF to prevent current from flowing through either of the current paths 12, 14. This process will now be described in greater detail.

As described above, if the current and energy sensing module 20 detects a current spike that exceeds the predefined current and energy thresholds, the switch 16 is commanded OFF. In one example the current threshold may be within the range of 50-75 Amps. In one example the energy threshold may be in the range of 100-300 mJ. Of course, other current and energy thresholds could be used. The time from detection of the overcurrent condition to turn OFF of the switch 16 may be on the order of several microseconds such that the switch 16 turns OFF quickly enough to protect itself. However, the overcurrent detection device 26 may need a greater amount of time (e.g. several milliseconds) to detect its predefined fault condition. Therefore, the quick turnoff time of the switch 16 prevents the overcurrent detection device 26 from detecting the fault condition through the first current path 12.

Once the switch 16 turns OFF to interrupt the flow of current along current path 12, the inductor 28 discharges its stored energy as current. Because of the abrupt change in current ($\Delta I$) within the time period following the turn OFF of the switch 16 ($\Delta t$), a voltage across the TVS device 24 is produced as a voltage spike. The magnitude of the voltage generated by the inductor 28 may be expressed using equation #1 below, and the magnitude of the energy stored in the inductor 28 may be expressed using equation #2 below.

$$V = L * \frac{\Delta I}{\Delta t}$$

equation #1

$$E = \frac{1}{2} * L * I^2$$

equation #2

where

V is a voltage generated by the inductor 28;
I is the current flow through the inductor 28 before switch 16 starts to switch OFF;
L is the inductance of the inductor 28; and
E is the energy stored in the inductor 28.

The energy stored in the inductor 28 is discharged through the TVS device 24 if the generated voltage V is greater than the breakdown voltage of the TVS. The inductance of the inductor 28 and the breakdown voltage of the TVS device 24 may be selected such that this discharge is sufficient to cause the TVS device 24 to start conducting along the second current path 14. In one example the TVS device 24 is selected to have a conduction threshold that is 10-20 volts lower than a rating of the solid state switch 16. However, these are only example values and it is understood that other conduction thresholds could be used.

When the TVS device 24 is conducting, the inductor 28 discharges through the TVS device 24. Because the discharged current resembles the downstream fault condition that caused the switch 16 to open, by analyzing the discharged current, the overcurrent detection device 26 is able to determine if the overcurrent condition corresponds to a predefined fault condition (e.g. at node 30). As described above, the predefined fault condition may include an arc fault condition or a ground fault condition, for example. If the overcurrent condition that caused the switch 16 to turn OFF corresponds to an arc fault condition, the overcurrent detection device 26 is able to trip to protect the circuit 10 despite the possible premature stop of current flow along the first current path 12. In one example the overcurrent detection device 26 analyzes the downstream overcurrent condition exclusively through the second current path 14. However, it is possible that the overcurrent detection device 26 could analyze the downstream overcurrent condition partially through the first current path 12 (before the switch 16 turns OFF) and partially through the second current path 14.

In one example, the switch 16 will automatically turn ON again after a delay (e.g. at a zero-crossing voltage of a subsequent half AC cycle), at which time the circuit 10 is ready to react to the next potential downstream overcurrent condition. Thus, the circuit 10 enables effective protection of the switch 16 and effective compliance with electrical codes requiring AFCI usage such that the switch 16 is able to open fast enough to protect itself and the current path 14 is able to provide a current representing a downstream arc and the arc pattern to enable the overcurrent detection device 26 to trip.

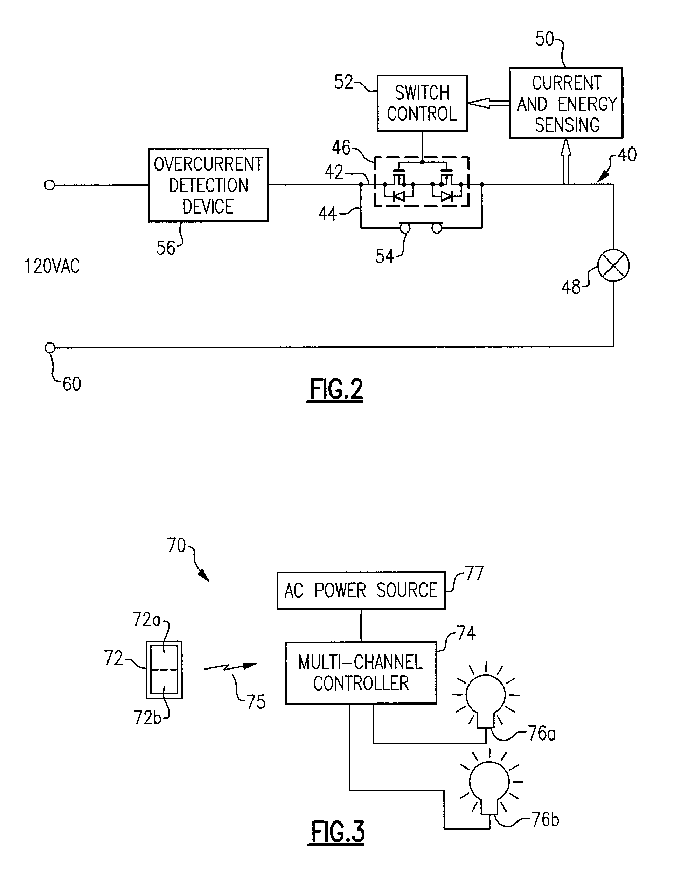

Figure 2 schematically illustrates another example branch circuit 40 with arc fault protection. The circuit 40 includes a first current path 42 and a second current path 44 connected in parallel to the first current path 42. The first current path 42 includes a solid state switch 46 operable to control a flow of current along the first current path 42 to a load 48. As in the circuit 10, the switch 46 may include one or more MOSFETS and the load 48 may include a lighting load such that the switch 46 is operable to perform a dimming function on the lighting load. Of course, other switches 46 and loads 48 could be used.

A current and energy sensing module 50 is operable to determine if a flow of current through the current path 42 exceeds a predefined current threshold and a predefined energy threshold. If the flow of current through the current path 42 exceeds the predefined current and energy thresholds (e.g. the current exceeds the predefined current threshold for an amount of time such that the flow of current exceeds the energy threshold) then the current and energy sensing module 50 commands switch control 52 to turn the switch 46 OFF such that the flow of current along path 42 is interrupted and current flows through the second current path 44. As with the circuit 10, by turning OFF the switch 46, the switch 46 is protected from potential damage from the overcurrent condition.

The second current path 44 includes an electro-mechanical switch 54. Under normal non-fault operating conditions, the switch 54 is OFF such that current is only able to pass through the current path 42 (depending on the state of the switch 46). In response to the solid state switch 46 turning OFF, the electromechanical switch 54 turns ON to permit a flow of current along the current path 44. The flow of current along current path 44 enables the overcurrent detection device 56 to trip and protect the circuit 40 and load 48 if the overcurrent condition corresponds to a predefined fault condition (e.g. at node 60). As described above in connection with the branch circuit 10, the overcurrent detection device 56 may include at least one of an arc fault circuit interrupter, a ground fault circuit interrupter, or a standard circuit breaker, and the predefined fault condition may includes at least one of an arc fault condition, a ground fault condition, or an overcurrent condition of a predefined magnitude.

In one example the overcurrent detection device 56 analyzes the downstream overcurrent condition exclusively through the second current path 44. However, it is possible that the overcurrent detection device 56 could analyze the downstream overcurrent condition partially through the first current path 42 (before the switch 46 turns OFF) and partially through the second current path 44.

Thus, like the circuit 10, the circuit 40 enables effective protection of its switch 46 and effective compliance with electrical codes requiring AFCI usage such that the switch 46 is able to open fast enough to protect itself and the current path 44 is able to provide access to the downstream overcurrent condition to enable the overcurrent detection device 56 to detect downstream fault conditions.

Without the use of current paths 14, 44 the overcurrent detection devices 26, 56 may not be able to trip because the solid state switches 16, 46 may open prematurely before the overcurrent detection devices 26, 56 were able to detect predefined fault conditions. This could result in the circuit 10, 40 potentially failing building inspections due to the lack of arc fault detection compatibility through the overcurrent detection devices 26, 56. By selectively passing current along the second current paths 14, 44 that are parallel to the first current paths 12, 42, the overcurrent detection devices 26, 56 are able to detect arc fault conditions downstream of the current paths 12-14 despite the overcurrent detection devices 26, 56 being located upstream of the current paths 12-14, 42-44. Thus, operation of the overcurrent detection devices 26, 56 is not interrupted by operation of solid state switches 16, 46.

Figure 3 schematically illustrates an example wireless switching application 70 for the branch circuits 10, 40 of Figures 1-2. A self-energizing switch 72 is operable to communicate wirelessly with a multi-channel controller 74. Actuation of switch portions 72a or 72b causes the switch 72 to harvest energy to transmit one or more wireless signals 75. The controller 74 is operable to selectively connect the lighting loads 76a-b to an AC power source 77 by commanding the lighting loads 76a-b ON or OFF in response to the one or more wireless signals 75. Each of the lighting loads 76a-b corresponds to channels of the multi-channel controller 74. Although only two channels are illustrated, it is understood that the controller 74 could include other quantities of channels.

The controller 74 may include one of the branch circuits 10, 40 with overcurrent protection such that overcurrent protection (e.g. AFCI protection) could be included in the wireless switching application 70. In one example the controller 74 incorporates the branch circuit 10 with arc fault protection such that the controller 74 includes the second current path 14 and a plurality of the first current paths 12, with each of the plurality of first current paths corresponding to a channel of the multi-channel controller 74. In this example the controller 74 could include only a single inductor 28 and a single TVS device 24 for the compatibility of fault condition detection through the overcurrent detection device 26.

In one example, the controller 74 incorporates the branch circuit 40 such that the controller 74 includes the current paths 42, 44 in each of its channels and such that each channel includes both the switch 46 and the switch 54.

Although embodiments have been disclosed, a worker of ordinary skill in this art would recognize that certain modifications would come within the scope of this disclosure. For that reason, the following claims should be studied to determine the true scope and content of this disclosure.

**Claims**

1. An electrical circuit, comprising:

at least one first current path including a load and a switch operable to control a flow of current to the load;
a second current path connected in parallel to the at least one first current path, the second current path including a transient voltage suppression ("TVS") device; and
an overcurrent detection device upstream of the current paths, wherein the switch is operable to turn OFF to prevent a flow of current through the first current path in response to an overcurrent condition exceeding a predefined threshold, such that the overcurrent detection device is operable to detect at least partially through the second current path if the overcurrent condition corresponds to a predefined fault condition.

2. The circuit of claim 1, wherein the load includes a lighting load, and wherein the switch is operable to perform a dimming function on the lighting load.

3. The circuit of claim 1, including a sensing module operable to detect when the current in the first current path exceeds the predefined thresholds, and operable to command a switch control to turn the switch ON or OFF.

4. The circuit of claim 1, including:

an inductive winding connected between the overcurrent detection device and the two current paths, the inductive winding discharging stored energy in response to the switch turning OFF, the energy being discharged as current into the TVS device such that the TVS device begins conducting if the energy stored in the inductive winding exceeds a TVS conduction threshold.

5. The circuit of claim 1, wherein the TVS device includes at least one of a zener diode or a metal oxide varistor, and wherein the switch is a solid state switch.

6. The circuit of claim 1, wherein the at least one current path includes a plurality of first current paths, each of the plurality of first current paths corresponding to a channel of a multi-channel controller, each channel having its own individually controllable load, such that only a single second current path is needed for the multi-channel controller.

7. The circuit of claim 1, wherein the overcurrent detection device includes at least one of an arc fault circuit interrupter, a ground fault circuit interrupter, or a standard circuit breaker, and wherein the predefined fault condition includes at least one of an arc fault condition, a ground fault condition, or an overcurrent condition of a predefined magnitude.

8. The circuit of claim 1, wherein the predefined threshold is at least a current threshold.

9. The circuit of claim 1, wherein the predefined threshold is at least an energy threshold.

10. An electrical circuit, comprising:

an overcurrent detection device;
a solid state switch downstream of the overcurrent detection device forming a first current path;
an electromechanical switch forming a second current path parallel to the first current path; and
a load downstream of the current paths, wherein if a flow of current to the load exceeds a predefined threshold the solid state switch turns OFF and the electromechanical switch turns ON to protect the solid state switch from the overcurrent condition, enabling the overcurrent detection device to detect through the second current path if the flow of current to the load corresponds to a predefined fault condition.

11. A method of protecting against overcurrent conditions, comprising:

controlling a solid state switch to turn OFF to prevent a flow of current along a first current path in response to an overcurrent condition exceeding a predefined threshold;
selectively passing current along a second current path that is parallel to the first current path in response to the solid state switch turning OFF; and
detecting at least partially via the second current path whether the overcurrent condition corresponds to a predefined fault condition downstream of the current paths using an overcurrent detection device upstream of the first current path and the second current path.

12. The method of claim 11, including:

preventing current from flowing through the second current path in response to the solid state switch being ON.

13. The method of claim 11, wherein said selectively passing current along a second current path that is parallel to the first current path in response to the solid state switch turning OFF includes:

storing energy in an inductive winding upstream of the two current paths; and
discharging the stored energy into a transient voltage suppression ("TVS") device in the second current path in response to the solid state switch turning OFF such that the TVS device can begin conducting if the energy stored in the inductive winding exceeds a TVS conduction threshold.

14. The method of claim 11, wherein said selectively passing current along a second current path that is parallel to the first current path in response to the solid state switch turning OFF includes:

turning ON an electromechanical switch to permit a flow of current along the second current path in response to the solid state switch turning OFF.

15. The method of claim 14, wherein a lighting load is located downstream of the first current path and the second current path, and wherein the solid state switch is operable to perform a dimming function on the lighting load when the electromechanical switch is turned OFF.

**FIG.1**

OVERCURRENT
DETECTION
DEVICE

SWITCH
CONTROL

CURRENT
AND ENERGY
SENSING

52

50

46

42

44

54

40

48

56

120VAC

60

**FIG.2**

70

AC POWER SOURCE

77

72a

72

72b

75

MULTI-CHANNEL
CONTROLLER

74

76a

76b

**FIG.3**